# EUROPEAN PATENT APPLICATION

(11) **EP 3 663 717 A1**
(43) Date of publication of application: **10.06.2020**
(21) Application number: 19211970.9
(22) Date of filing: 27.11.2019
(51) Int. Cl.: G01C 19/5691

(54) **SYSTEM AND METHODS FOR OPTICAL EXCITATION OF ACOUSTIC RESONANCE IN RESONATOR GYROSCOPES**

(30) Priority: 03.12.2018 US 201862774556 P; 06.06.2019 US 201916433911
(71) Applicant: Honeywell International Inc., Morris Plains, NJ 07950 (US)
(72) Inventor: FREEMAN, Eugene, Morris Plains, NJ 07950 (US); FERTIG, Chad, Morris Plains, NJ 07950 (US)
(74) Representative: Haseltine Lake Kempner LLP

(57) **Abstract**

In one embodiment, a resonator gyroscope device comprises: a sealed vacuum cavity; a resonator positioned within the cavity, wherein the resonator comprises a resonating shell coupled to a stem; at least one light source that generates an optical excitation signal directed onto the resonating shell of the resonator; a controller coupled to the light source; at least one optical signal interrogation device; and measurement processor coupled to the at least one optical signal interrogation device; wherein the controller controls the at least one light source to selectively heat a portion of the resonating shell in a manner that excites the resonating shell into a state of resonance; wherein the at least one optical signal interrogation device measures a movement of a standing wave in the resonating shell and the measurement processor outputs rotational data based on the movement measured by the at least one optical signal interrogation device.

## Description

### BACKGROUND

A Hemispherical Resonator Gyroscope (HRG) is a type of gyroscope that utilizes a thin hemispherical shell resonator that is often anchored to a base by a relatively thicker stem. The hemispherical shell is typically driven to a flexural resonance by electrostatic forces generated by conductive electrodes deposited on a fused-quartz shell. The HRG's gyroscopic effect is produced by the inertial property of flexural standing waves produced in the shell. Notably, HRGs are extremely reliable because of their lack of moving parts. However, HRGs are expensive to manufacture due to the high costs of the precision ground and polished hollow quartz hemispherical shells utilized. Furthermore, these manufacturing techniques fundamentally limit the minimum size of HRGs, deeming them unsuitable for certain platforms having size and weight limitations.

Glass-blown Micro-Electro-Mechanical Systems (MEMS) HRGs are one type of HRG that have been produced in laboratories, exhibiting high quality-factors (e.g., Q-factors >1 million) and long ring-down times (e.g., >250 secs). However, in order to function as gyroscopes, vibratory motion must be induced in these HRGs. One approach is to deposit metal conductors on the HRG, and utilize the metal conductors to induce the vibratory motion through electrostatic actuation. However, the presence of the metal conductors significantly degrades the ultra-low-loss acoustic resonance of the HRG. Another approach is to utilize a piezoelectric structure to induce the vibratory motion in the HRG, but this approach generates a significant amount of un-wanted vibration because the vibratory motion induced by the piezoelectric structure must be coupled to the HRG through its stem.

For the reasons stated above and for other reasons stated below which will become apparent to those skilled in the art upon reading and understanding the specification, the need exists in the art for a technique that can be utilized to overcome the above-described problems associated with, for example, the utilization of metal conductors and/or piezoelectric structures to induce vibratory motion in HRGs.

### SUMMARY

The embodiments of the present disclosure provide methods and systems for optical excitation of acoustic resonance in hemispherical resonator gyroscopes and will be understood by reading and studying the following specification.

In one embodiment, a resonator gyroscope device comprises: a sealed vacuum cavity; a resonator positioned within the sealed vacuum cavity, wherein the resonator comprises a resonating shell coupled to a stem; at least one light source, that is utilized to generate an optical excitation signal directed onto the resonating shell of the resonator; a controller coupled to the at least one light source; at least one optical signal interrogation device; and measurement processor coupled to the at least one optical signal interrogation device; wherein the controller controls the at least one light source to selectively heat a portion of the resonating shell in a manner that excites the resonating shell into a state of resonance; wherein the at least one optical signal interrogation device measures a movement of a standing wave in the resonating shell and the measurement processor outputs rotational data based on the movement measured by the at least one optical signal interrogation device.

### DRAWINGS

Embodiments of the present disclosure can be more easily understood and further advantages and uses thereof more readily apparent, when considered in view of the description of the preferred embodiments and the following figures in which:
Figures 1 and 2 are diagrams illustrating an example embodiment of a hemispherical resonator gyroscope of the present disclosure;
Figure 3 and 3A are diagrams illustrating an example of optical excitation for a hemispherical resonator gyroscope of the present disclosure; and
Figure 4 is a flow chart illustrating and example method embodiment for optical excitation of acoustic resonance in a hemispherical resonator gyroscope.

In accordance with common practice, the various described features are not drawn to scale but are drawn to emphasize features relevant to the present disclosure. Reference characters denote like elements throughout the figures and text.

### DETAILED DESCRIPTION

In the following detailed description, reference is made to the accompanying drawings that form a part hereof, and in which is shown by way of specific illustrative embodiments in which the embodiments may be practiced. These embodiments are described in sufficient detail to enable those skilled in the art to practice the embodiments, and it is to be understood that other embodiments may be utilized and that logical, mechanical and electrical changes may be made without departing from the scope of the present disclosure. The following detailed description is, therefore, not to be taken in a limiting sense.

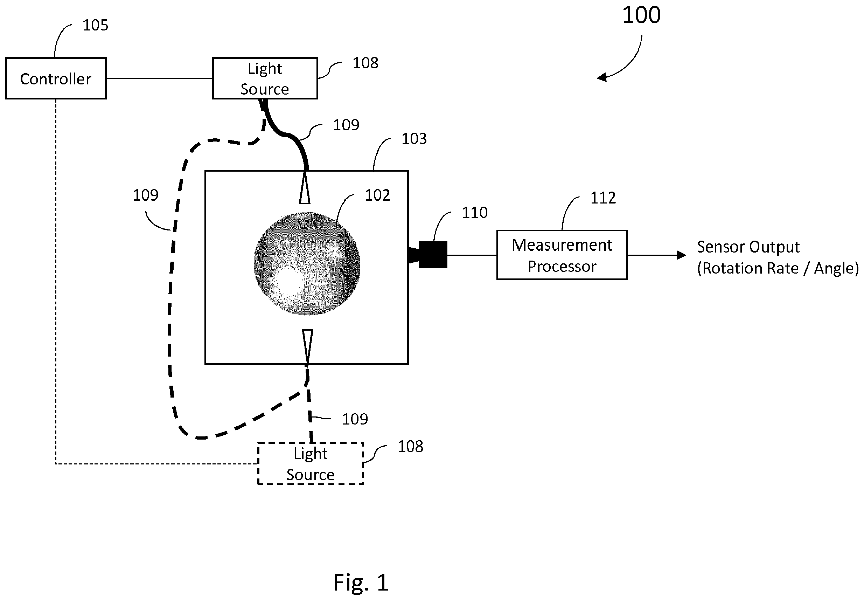

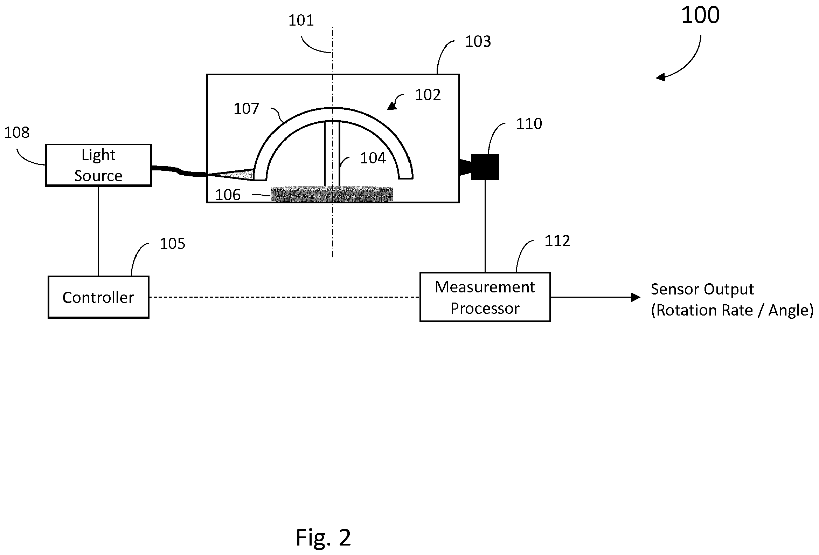

Figures 1 and 2 are block diagrams illustrating an example device embodiment of a hemispherical resonator gyroscope (HRG) 100 of the present disclosure in which optical excitation is used to initiate acoustic resonance. Optical energy is used to selectively heat a resonating component of the gyroscope. The optical energy has a wavelength that falls within the spectrum of electromagnetic radiation that is at least partially absorbed by the resonating component and the localized heating produce acoustic vibrations at the resonance frequency (for example, at 10 kHz) of the gyroscope. Although optical energy may be referred to herein generally as "light" or "light beams" that may be generated, for example, by a "light source", such usage of the term "light" is not intended to limit or imply that the optical energy must fall within a spectrum of electromagnetic radiation visible to human beings.

HRG 100 comprises a resonator 102 that includes a micro-shell referred to herein as a resonating shell 107 and a stem 104 that anchors the resonator 102 to a substrate 106. Throughout this disclosure, the resonator 102 may alternately be referred to as a "hemispherical" resonator 102. Similarly, the resonating shell 107 may alternately be referred to as a "hemispherical" resonator 102. It should be noted that the "hemispherical" prefix used herein is intended as generally descriptive adjective and not intended to implicate that the shape of the element is perfectly hemispherical or a perfect half-sphere. For example, resonator elements having what may be referred to as "bird-bath", "bubble", "elliptical" or "wine-glass" shapes may be considered hemispherical elements. It should be understood that a "hemispherical" element may comprise additional features, such as a stem, for securing or mounting the element in place. In other embodiments, the resonator 102 and/or resonating shell 107 may comprise a hemitoroidal shape (such as illustrated in United States Patent 8,631,702, which is incorporated herein by reference) a cylindrical shell, or otherwise having cylindrical symmetry. It should be understood that a resonator gyroscope comprising a resonating shell with any of the alternative shapes just described would still generally be referred to by those of ordinary skill in the relevant art as a hemispherical resonator gyroscope (HRG). It should also be understood that the embodiments disclosed herein are not limited to microscale resonator gyroscopes, but may be applied to macro-scale resonator gyroscopes as well.

In the embodiment shown in Figures 1 and 2, the resonator 102 comprises a MEMS micro-shell which may be fabricated from Quartz, fused silica, fluoride, calcium fluoride, borosilicate, a lithium-aluminosilicate glass-ceramic (for example, ZERODUR®), or other forms of glass, for example. In some embodiments, the material of the resonator 102 may be selected based on having a low thermal coefficient of expansion. For example, calcium fluoride glass can have a low thermal coefficient in the range of 6.7× 10⁻⁶ K⁻¹ to 22.2 × 10⁻⁶ K⁻¹, borosilicate glass has a low thermal coefficient of expansion of about 3 × 10⁻⁶ K⁻¹, fused quartz has a low coefficient of thermal expansion of about 0.55 . 10⁻⁶ K⁻¹ , ULE® glass has a low thermal coefficient of expansion of about 0.03 × 10⁻⁶ K⁻¹ near room temperature, and ZERODUR® has a low coefficient of thermal expansion of about 0.05 ± 0.10×10⁻⁶ K⁻¹. As such, alternate embodiments may include resonators 102 made of such materials or other glass type material having similarly low or lower coefficients of thermal expansion. The particular material may therefore also be selected at least in part as a function of its coefficient of thermal expansion, the amount of thermal energy expected to be absorbed by the resonator 102 from the applied light beams, and the degree of thermal expansion and contraction that is expected to drive the acoustic frequency motion of the resonator shell. It should be noted that depending on other damping mechanism that may be present, there may be a point where no further advantage is obtained by having a still lower coefficient of thermal expansion because the other damping mechanism will dominate the loss considerations. However, one skilled in the art who has studied this specification would be readily able to take such factors into consideration in addition to the other factors discussed herein, in order to select materials for resonator 102 for their particular application.

In one embodiment, the resonator 102 comprises a glass-blown resonator made of fused silica formed into a 3-dimensional shell resonator utilizing a MEMS fabrication process. In some embodiments, the stem 104 is anchored to the substrate 106 via a glass frit or bonded to the substrate 106 by other techniques. The resonator 102 is located within vacuum cavity 103 that is at least partially evacuated and sealed. In some embodiments, during fabrication the vacuum cavity 103 may be completely evacuated and the backfilled with a gas to a desired pressure in order to provide a desired level of dampening on the resonator 102.

The hemispherical resonator gyroscope 100 further comprises at least one light source 108 that is utilized to generate optical excitation signals (e.g., light beams) that are directed at the resonating shell 107 of the resonator 102. In some embodiments, light beams generated by the light source 108 are directed into the vacuum cavity 103 by a waveguide 109 coupled to an output of the light source 108. In alternate embodiments, waveguide 109 may be implemented, for example, by rigid waveguide elements, optical fibers, an on-chip integrated optical waveguide, a multi-chip waveguide (for example, where a resonator shell 107 and the optical components are on separate, but interacting and optionally bonded die), or a combination thereof. In some embodiments, light source(s) 108 may be implemented on-chip with the vacuum cavity 103 and resonator 102 elements. In other embodiments the light source(s) 108 may be implemented off-chip and the light from light source(s) 108 brought to the vacuum cavity by one or more waveguides 109.

It should be noted that although Figures 1 and 2 only illustrates a single light source 108, in other embodiments additional light sources 108 may similarly be utilized to direct light beams into the vacuum cavity 103 via waveguide 109 that are directed at the resonating shell 107 of the resonator 102. The light sources may be phase locked or have phase offsets between each other or some combination thereof. For example, in a region of the resonator shell 107 timed to have minimal acoustic expansion it may be desirable to impart optical energy 180 degrees out of phase from a region timed to have maximum acoustic displacement. In still other embodiments, light generated by a single light source 108 may be split and/or coupled into separate waveguides 109 that direct the light beams at the resonating shell 107 from different directions. In some embodiments, the light source(s) 108 maybe laser light sources such as, but not limited to a diode laser. In some embodiments, the light source(s) 108 may comprise a 4.8 µm diode laser 308. Is should also be noted that in some embodiments, light source(s) 108 may optionally be fabricated onto a substrate within the vacuum cavity 103 so that their output may be directly emitted onto the resonating shell 107.

In the embodiment shown in Figures 1 and 2, hemispherical resonator gyroscope 100 comprises a controller 105 to control the operation of light source(s) 108. In some embodiments, the controller 105 may control the light source(s) 108. For example, controller 105 may control the light source(s) 108 to energize or de-energize the light beam output. In some embodiments, control of the light source(s) 108 may involve pulsing and/or cycling the output of the light source(s) 108, or modulating the amplitude of the output of the light source(s) 108 at the resonant frequency of the resonator gyroscope. In other embodiments, the controller 105 may control the wavelength of the light beams emitted from the light source(s) 108. In some embodiments, the controller 105 may control the phase offsets of the light beams emitted from the light source(s) 108. Hemispherical resonator gyroscope 100 further comprises at least one optical signal interrogation device 110 coupled to a measurement processor 112. As further described in detail below, the optical signal interrogation device 110 is positioned to observe the movement of standing waves that develop in the resonator 102 and provide corresponding data in an output signal to the measurement processor 112. In alternate embodiments, the optical signal interrogation device 110 may be implemented off-chip on a substrate separate from the vacuum cavity 103, or optionally integrated on-chip, for example fabricated onto a substrate with the vacuum cavity 103.

The measurement processor 112 may then convert the data from the optical signal interrogation device 110 into rotational data, such as an angle of rotation and/or a rotation rate with respect to rotation about the axis 101 of the resonator 102. In some embodiments, data received from the optical signal interrogation device 110 may be provided as feedback by the measurement processor 112 to the controller 105 for adjusting operation of the light source(s) 108 or for other purposes. The controller 105 may be implemented, for example, using a processor coupled to a memory, an application specific integrating circuit (ASIC), or similar processing device configured to execute application-specific digital/analog instructions and may comprises a suitable sine wave generator or other signal generator which may provide an output to the light source(s) 108 for modulating the output from the light source(s) 108. In some embodiments, the functions associated with the measurement processor 112 and controller 105 may both be implemented by a single processing device.

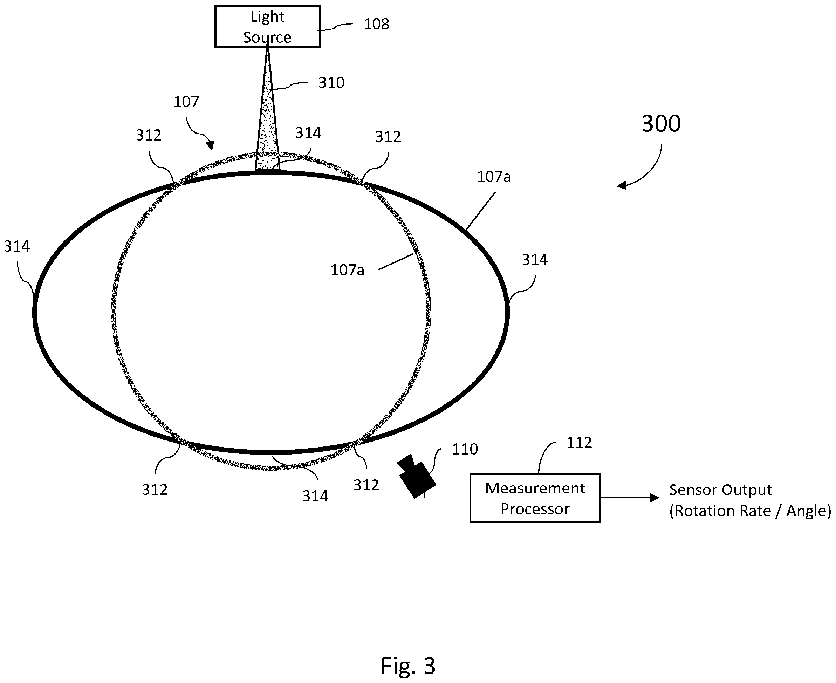

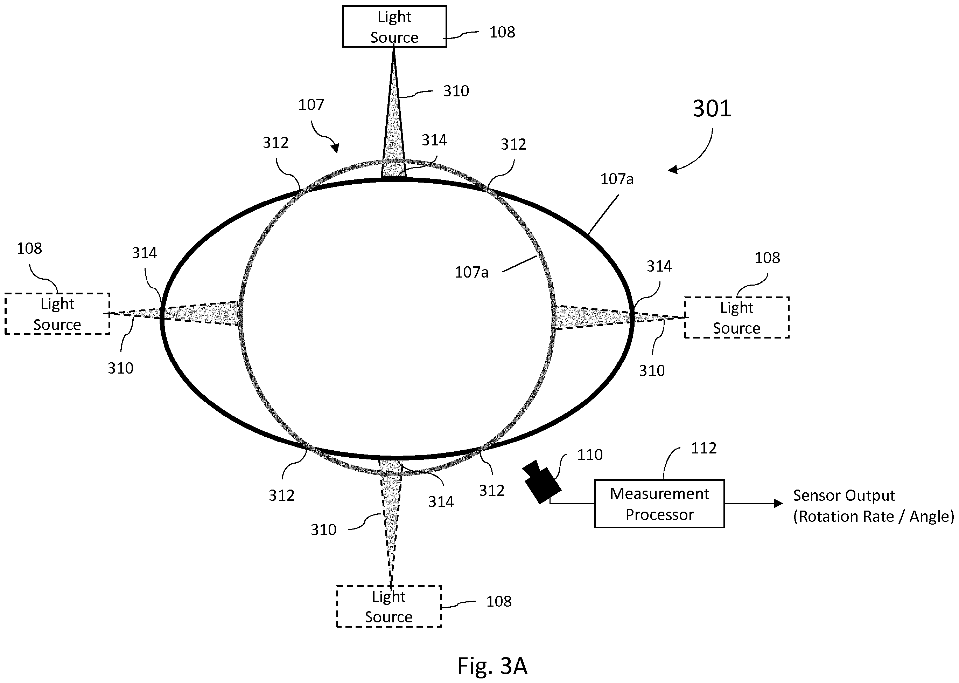

In operation, the light beams generated from the light source(s) 108 are directed onto the resonator 102 in order to selectively heat portions of the resonating shell 107 in a controlled manner so as to excite the resonating shell 107 into a state of resonance (for example, to excite the resonating shell 107 into a fundamental resonance consisting of an acoustic standing wave having a primary and secondary wave around the perimeter of the shell, also known as the (N=2) mode), as illustrated in Figure 3 at 300 (where a resulting set of four nodes 312 and four anti-nodes 314 are generated in the N=2 mode). Alternatively, a standing wave consisting of any integer number of waves around the perimeter of the shell could be excited. More particularly, the energy of a time-dependent optical excitation signal 310 (i.e., a light beam) generated by at least one light source 108 is being utilized to induce motion at an acoustic frequency in the resonating shell 107 by thermally expanding and contracting the resonating shell 107 at its acoustic resonant frequency. The mechanical stresses induced by thermal expansions and contractions drive the acoustic frequency motion of the resonator shell. As such, the wavelength of the light beam 310 would be set to a wavelength of light that is absorbed by the material of the resonating shell 107 so as to produce heating. For example, in the case of a quartz material, the light source(s) 108 may be selected or adjusted to produce a light beam 310 in the infrared (IR) or ultraviolet (UV) spectrums.

In any event, the resonating shell 107 is illuminated by the excitation signal 310 (at one or more locations and generated by one or more light sources 108) so that the optical radiation can be strongly absorbed by the resonator 102 and thereby induce a significant amount of vibrational motion in the resonating shell 107. In one embodiment, with the excitation signal 310 amplitude modulated at the mechanical resonance frequency of the resonating shell 107, standing waves form in the resonating shell 107 resulting in nodes 312 and anti-nodes 314 in the N=2 mode. Reference 107a represents an undistorted resonating shell 107 not excited to resonate, whereas reference 107b represents the distortion of resonating shell 107 when excited to resonance. Nodes 312 occur at points on the perimeter of the resonating shell 107 where no displacement occurs during each vibrational cycle of the standing wave. In contrast, the anti-nodes 314 are points on the perimeter of the resonating shell 107 that undergo a maximum displacement during each vibrational cycle of the standing wave. Figure 3A illustrates an implementation at 301 where the standing wave is produced in resonating shell 107 by multiple excitation signals 310 generated by a plurality of light sources 108.

In some embodiments, the controller 105 outputs a control signal (for example, an approximately 10 kHz sine wave signal) which causes the light source(s) 108 to output an amplitude modulated excitation signal 310 (for example, a 4.8 µm wavelength optical signal) modulated at approximately 10 kHz (1). One side of the resonating shell 107 is illuminated by the excitation signal 310 and absorbs the excitation signal. The resonating shell 107 becomes differentially stressed to excite the N=2 mode (e.g., nodes 312 and anti-nodes 314). As previously mentioned, movement of the standing wave around the resonating shell 107 will occur in response to a rate input (i.e., a rotation of the device about axis 101). Accordingly, in some embodiments, the actuation of resonance in the resonating shell 107 by the excitation signal 310 may be adjusted by the controller 105 (for example, using feedback from the optical signal interrogation device 110 and/or measurement processor 112) to account for that rotation.

As described above with respect to Figure 1, the optical signal interrogation device 110 may then be used to detect and measure the movement of the position of the nodes 312 and/or the anti-nodes 314 on the resonating shell 107 that occurs due to rotation of the hemispherical resonator gyroscope 100 about the axis 101 of the resonator 102. The frequency spectrum of the detected motion of the micro-shell resonator is then accumulated and analyzed by the measurement processor 112.

In some embodiments, the optical signal interrogation device 110 may comprise, for example, a laser vibrometer (such as a laser doppler vibrometer, for example) or an interferometer, or other motion sensing technology, utilized to detect the motion of the nodes 312 and/or anti-nodes 314 in order to measure the rotation of the standing wave in the resonator 102. In some embodiments, a portion of the excitation light beam directed at the resonating shell 107 is coupled to the optical signal interrogation device 110, which detects the motion of the nodes 312 and/or the anti-nodes 314. The frequency data associated with the detected motion is then coupled from the optical signal interrogation device 110 to the measurement processor 112 accumulation and analysis. In some embodiments, the optical excitation signals 310 enter the vacuum cavity 103 via a window in the vacuum cavity (which may comprise, for example, a calcium fluoride or borosilicate window). Similarly, the optical signal interrogation device 110 may detect the motion of the nodes 312 and/or the anti-nodes 314 via a window in the vacuum cavity (which may comprise, for example, a calcium fluoride or borosilicate window). Alternatively, an on-chip integrated optical waveguide, a bonded chip waveguide system, or a multi-chip waveguide may be incorporated to facilitate detect the motion of the nodes 312 and/or the anti-nodes 314 by the optical signal interrogation device 110.

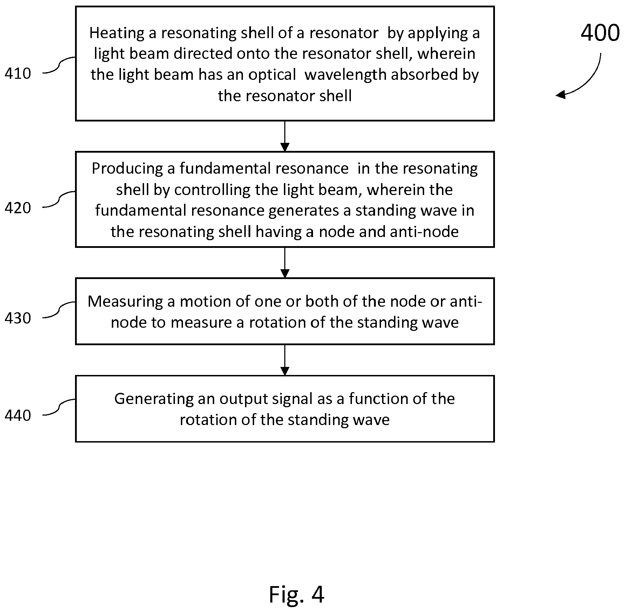

Figure 4 is a flow chart illustrating a method 400 for optical excitation of acoustic resonance in a hemispherical resonator gyroscope. It should be understood that the features and elements described herein with respect to the method 400 shown in Figure 4 and the accompanying description may be used in conjunction with, in combination with, or substituted for elements of any of the other embodiments discussed with respect to the other Figures, or elsewhere herein, and *vice versa.* Further, it should be understood that the functions, structures and other description of elements associated with embodiments of Figure 4 may apply to like named or described elements for any of the other figures and embodiments and *vice versa.*

The method 400 begins at 410 with heating a resonating shell of a hemispherical responator by applying a light beam directed onto the resonating shell, wherein the light beam has an optical wavelength absorbed by the resonating shell. The method proceeds to 420 with producing a fundamental resonance in the resonating shell by controlling (e.g. cycling or modulating) the light beam, wherein the fundamental resonance generates a standing wave in the resonating shell having two pairs of nodes and anti-nodes. The method proceeds to 430 with measuring a motion of the nodes and/or anti-nodes to measure a rotation of the standing wave and to 440 with generating an output signal as a function of the rotation of the standing wave.

Although Figures 1 and 2 illustrate a single-axis implementation of a hemispherical resonator gyroscope 100, it should be understood that in other embodiments, a hemispherical resonator gyroscope may comprise multiple resonators 102 oriented to measure rotation about different axes. For example, the output of the light sources(s) 108 may be directed to three separate resonating shells 107 of three independent (and in some embodiments, orthogonally aligned) resonators 102. In such an embodiment, a respective optical signal interrogation device 100 would measure the motion of a resonating shell 107 as described above. The data from each optical signal interrogation device 100 would then be fed to the measurement processor 112 to output three-dimensional rotation information.

### EXAMPLE EMBODIMENTS

Example 1 includes a resonator gyroscope device, the gyroscope device comprising: a sealed vacuum cavity; a resonator positioned within the sealed vacuum cavity, wherein the resonator comprises a resonating shell coupled to a stem; at least one light source that generates an optical excitation signal directed onto the resonating shell of the resonator; a controller coupled to the at least one light source; at least one optical signal interrogation device; and a measurement processor coupled to the at least one optical signal interrogation device; wherein the controller controls the at least one light source to selectively heat a portion of the resonating shell in a manner that excites the resonating shell into a state of resonance; wherein the at least one optical signal interrogation device measures a movement of a standing wave in the resonating shell and the measurement processor outputs rotational data based on the movement measured by the at least one optical signal interrogation device.
Example 2 includes the gyroscope device of example 1, wherein the controller causes the at least one light source to amplitude modulate the optical excitation signal at a resonance frequency of the resonating shell.
Example 3 includes the gyroscope device of any of examples 1-2, wherein the optical excitation signal directed onto the resonating shell is controlled by the controller to form a standing wave in the resonating shell having nodes and anti-nodes; and wherein the optical signal interrogation device measures the movement of the standing wave by measuring movement of one or both of the nodes and anti-nodes.
Example 4 includes the gyroscope device of any of examples 1-3, wherein the controller controls the at least one light source to: energize or de-energize the optical excitation signal; pulse or cycle the optical excitation signal; amplitude modulate the optical excitation signal; adjust a wavelength of the optical excitation signal.
Example 5 includes the gyroscope device of any of examples 1-4, wherein data received from the optical signal interrogation device is utilized to provide feedback by the measurement processor to the controller for adjusting operation of the at least one light source.
Example 6 includes the gyroscope device of any of examples 1-5, wherein the optical signal interrogation device comprises, a vibrometer or an interferometer.
Example 7 includes the gyroscope device of any of examples 1-6, wherein the optical excitation signal is directed into the vacuum cavity by a waveguide coupled to an output of the at least one light source.
Example 8 includes the gyroscope device of any of examples 1-7, wherein the optical excitation signal is split and directed into the vacuum cavity to illuminate the resonating shell at different locations.
Example 9 includes the gyroscope device of any of examples 1-8, wherein the at least one light source comprises a first light source emitting a first optical excitation signal and a second light source emitting a second optical excitation signal; wherein the first optical excitation signal and the second optical excitation signal illuminate the resonating shell at different locations.
Example 10 includes the gyroscope device of any of examples 1-9, wherein the at least one light source is located within the vacuum cavity.
Example 11 includes the gyroscope device of any of examples 1-10, wherein the resonator comprises a Micro-Electro-Mechanical Systems (MEMS) resonating shell fabricated from a material comprising one of: Quartz, fused silica, fluoride, calcium fluoride, borosilicate, a lithium-aluminosilicate glass-ceramic, or other forms of glass.
Example 12 includes the gyroscope device of any of examples 1-11, wherein the controller adjust application of the optical excitation signal to account for rotation detected by the optical signal interrogation device.
Example 13 includes a method for optical excitation of acoustic resonance in a resonator gyroscope, the method comprising: heating a resonating shell of a resonator by applying a light beam directed onto the resonating shell, wherein the light beam has an optical wavelength absorbed by the resonating shell, and wherein the resonator is located within a vacuum cavity; producing a fundamental resonance in the resonating shell by controlling the light beam, wherein the fundamental resonance generates a standing wave in the resonating shell having a node and anti-node; measuring a motion of one or both of the node or anti-node to measure a rotation of the standing wave; and generating an output signal as a function of the rotation of the standing wave.
Example 14 includes the method of example 13, further comprising: utilizing the light beam directed onto the resonating shell, forming a standing wave in the resonating shell having nodes and anti-nodes; and measuring the movement of the standing wave by measuring movement of one or both of the nodes and anti-nodes.
Example 15 includes the method of any of examples 13-14, further comprising: modulating the light beam at a resonance frequency of the resonating shell.
Example 16 includes the method of any of examples 13-15, the method further comprising: directing the light beam into the vacuum cavity by utilizing a waveguide coupled to an output of a light source generating the light beam.
Example 17 includes the method of any of examples 13-16, the method further comprising: generating the light beam from at least one light source located within the vacuum cavity.
Example 18 includes the method of any of examples 13-17, further comprising: splitting the light beam; and directing the light beam into the vacuum cavity to illuminate the resonating shell at different locations.
Example 19 includes the method of any of examples 13-18, wherein the resonator comprises a Micro-Electro-Mechanical Systems (MEMS) resonating shell fabricated from a material comprising one of: Quartz, fused silica, fluoride, calcium fluoride, borosilicate, a lithium-aluminosilicate glass-ceramic, or other forms of glass.
Example 20 includes the method of any of examples 13-19, wherein measuring a motion of one or both of the node or anti-node to measure a rotation of the standing wave comprises measuring the motion by utilizing a vibrometer or an interferometer.

It should be understood that elements of the above described embodiments and illustrative figures may be used in various combinations with each other to produce still further embodiments which are explicitly intended as within the scope of the present disclosure.

Although specific embodiments have been illustrated and described herein, it will be appreciated by those of ordinary skill in the art that any arrangement, which is calculated to achieve the same purpose, may be substituted for the specific embodiment shown. This application is intended to cover any adaptations or variations of the presented embodiments. Therefore, it is manifestly intended that embodiments be limited only by the claims and the equivalents thereof.

## Claims

1. A resonator gyroscope device (100), the gyroscope device (100) comprising:
a sealed vacuum cavity (103);
a resonator (102) positioned within the sealed vacuum cavity (103), wherein the resonator (102) comprises a resonating shell (107) (107) coupled to a stem (104);
at least one light source (108) that generates an optical excitation signal directed onto the resonating shell (107) of the resonator (102);
a controller (105) coupled to the at least one light source (108);
at least one optical signal interrogation device (110); and
a measurement processor (112) coupled to the at least one optical signal interrogation device (110);
wherein the controller (105) controls the at least one light source (108) to selectively heat a portion of the resonating shell (107) in a manner that excites the resonating shell (107) into a state of resonance;
wherein the at least one optical signal interrogation device (110) measures a movement of a standing wave in the resonating shell (107) and the measurement processor (112) outputs rotational data based on the movement measured by the at least one optical signal interrogation device (110).

2. The gyroscope device (100) of claim 1, wherein the controller (105) causes the at least one light source (108) to amplitude modulate the optical excitation signal at a resonance frequency of the resonating shell (107).

3. The gyroscope device (100) of claim 1, wherein the optical excitation signal directed onto the resonating shell (107) is controlled by the controller (105) to form a standing wave in the resonating shell (107) having nodes (312) and anti-nodes (314); and
wherein the optical signal interrogation device (110) measures the movement of the standing wave by measuring movement of one or both of the nodes (312) and anti-nodes (314).

4. The gyroscope device (100) of claim 1, wherein data received from the optical signal interrogation device (110) is utilized to provide feedback by the measurement processor (112) to the controller (105) for adjusting operation of the at least one light source (108).

5. The gyroscope device (100) of claim 1, wherein the optical excitation signal is directed into the vacuum cavity (103) by a waveguide (109) coupled to an output of the at least one light source (108).

6. The gyroscope device (100) of claim 1, wherein the at least one light source (108) is located within the vacuum cavity (103).

7. A method for optical excitation of acoustic resonance in a resonator gyroscope (100), the method comprising:
heating a resonating shell (107) of a resonator (102) by applying a light beam (310) directed onto the resonating shell (107), wherein the light beam (310) has an optical wavelength absorbed by the resonating shell (107), and wherein the resonator (102) is located within a vacuum cavity (103);
producing a fundamental resonance in the resonating shell (107) by controlling the light beam (310), wherein the fundamental resonance generates a standing wave in the resonating shell (107) having a node and anti-node;
measuring a motion of one or both of the node or anti-node to measure a rotation of the standing wave; and
generating an output signal as a function of the rotation of the standing wave.

8. The method of claim 7, further comprising:
utilizing the light beam (310) directed onto the resonating shell (107), forming a standing wave in the resonating shell (107) having nodes (312) and anti-nodes (314); and
measuring the movement of the standing wave by measuring movement of one or both of the nodes (312) and anti-nodes (314).

9. The method of claim 7, the method further comprising:
directing the light beam (310) into the vacuum cavity (103) by utilizing a waveguide (109) coupled to an output of a light source (108) generating the light beam (310).

10. The method of claim 7, wherein the resonator (102) comprises a Micro-Electro-Mechanical System (104)s (MEMS) resonating shell (107) fabricated from a material comprising one of: Quartz, fused silica, fluoride, calcium fluoride, borosilicate, a lithium-aluminosilicate glass-ceramic, or other forms of glass.

## Amended claims

### Amended claims in accordance with Rule 137(2) EPC.

1. A resonator gyroscope device (100), the gyroscope device (100) comprising:
a sealed vacuum cavity (103);
a resonator (102) positioned within the sealed vacuum cavity (103), wherein the resonator (102) comprises a resonating shell (107) (107);
at least one light source (108) that generates an optical excitation signal directed onto the resonating shell (107) of the resonator (102);
a controller (105) coupled to the at least one light source (108);
at least one optical signal interrogation device (110); and
a measurement processor (112) coupled to the at least one optical signal interrogation device (110);
wherein the controller (105) is configured to control the at least one light source (108) to selectively heat a portion of the resonating shell (107) in a manner that excites the resonating shell (107) into a state of resonance comprising a standing wave;
wherein the at least one optical signal interrogation device (110) is configured to measure a movement of the standing wave in the resonating shell (107) and the measurement processor (112) outputs rotational data based on the movement measured by the at least one optical signal interrogation device (110).

2. The gyroscope device (100) of claim 1, wherein the controller (105) causes the at least one light source (108) to amplitude modulate the optical excitation signal at a resonance frequency of the resonating shell (107).

3. The gyroscope device (100) of claim 1, wherein the optical excitation signal directed onto the resonating shell (107) is controlled by the controller (105) to form a standing wave in the resonating shell (107) having nodes (312) and anti-nodes (314); and
wherein the optical signal interrogation device (110) measures the movement of the standing wave by measuring movement of one or both of the nodes (312) and anti-nodes (314).

4. The gyroscope device (100) of claim 1, wherein data received from the optical signal interrogation device (110) is utilized to provide feedback by the measurement processor (112) to the controller (105) for adjusting operation of the at least one light source (108).

5. The gyroscope device (100) of claim 1, wherein the optical excitation signal is directed into the vacuum cavity (103) by a waveguide (109) coupled to an output of the at least one light source (108).

6. The gyroscope device (100) of claim 1, wherein the at least one light source (108) is located within the vacuum cavity (103).

7. A method for optical excitation of acoustic resonance in a resonator gyroscope (100), the method comprising:
heating a portion of a resonating shell (107) of a resonator (102) by applying a light beam (310) directed onto the resonating shell (107), wherein the resonator (102) is located within a vacuum cavity (103);
producing a state of resonance in the resonating shell (107) by controlling the light beam (310), wherein the state of resonance generates a standing wave in the resonating shell (107) ;
measuring a motion of the standing wave; and
generating an output signal as a function of the rotation of the standing wave.

8. The method of claim 7, wherein the light beam (310) has an optical wavelength absorbed by the resonating shell (107).

9. The method of claim 7, the method further comprising:
directing the light beam (310) into the vacuum cavity (103) by utilizing a waveguide (109) coupled to an output of a light source (108) generating the light beam (310).

10. The method of claim 7, wherein the resonator (102) comprises a Micro-ElectroMechanical System (MEMS) resonating shell (107) fabricated from a material comprising one of: Quartz, fused silica, fluoride, calcium fluoride, borosilicate, a lithium-aluminosilicate glass-ceramic, or other forms of glass.
